# DEMANDE DE BREVET EUROPEEN

(11) **EP 1 973 153 A1**
(43) Date de publication de la demande: **24.09.2008**
(21) Numéro de dépôt: 06125639.2
(22) Date de dépôt: 07.12.2006
(51) Int. Cl.: H01L 21/673, H01L 21/677

(54) **Enceinte étanche pour le transport et le stockage de substrats semi conducteurs**

(30) Priorité: 09.12.2005 FR 0553815
(71) Demandeur: Alcatel Lucent, 75008 Paris (FR)
(72) Inventeur: Bunod, Philippe, 74230 Serraval (FR); KAMBARA, Hisanori, 74350, VILLY-LE-PELLOUX (FR); Bernard, Roland, 74540 Viuz-la-Chiesaz (FR); Brandolin, Serge, 74000 Annecy (FR)
(74) Mandataire: Sciaux, Edmond

(57) **Abrégé**

La présente invention a pour objet une enceinte étanche pour le transport et le stockage de substrats semi-conducteurs comprenant un conteneur étanche et des moyens placés à l'intérieur du conteneur comprenant des plateaux pour supporter les substrats. Le conteneur comporte deux demi-coques jointives qui s'écartent pour assurer l'ouverture du conteneur, et chaque extrémité des moyens est mécaniquement solidaire respectivement de chacune desdites demi-coques. La hauteur totale des moyens varie selon que le conteneur est ouvert ou fermé, les plateaux étant séparés par une distance égale. De préférence les moyens comportent une alternance de segments et de rotules comprenant des segments d'extrémité relié mécaniquement respectivement à chacune des demi-coques. Dans ce cas la hauteur totale des moyens varie par un mouvement d'accordéon de l'alternance de segments et de rotules.

## Description

La présente invention se rapporte au domaine du transport et du stockage de substrat, notamment au cours des différentes étapes de la fabrication de composants micro-électroniques, par exemple pour la réalisation de composants de microsystèmes électromécaniques (MEMS) ou de microsystèmes électro-optomécaniques (MOEMS). Elle concerne plus particulièrement une enceinte étanche pour le transport et le stockage de ces substrats, qui se présentent notamment sous la forme de masques en verre de forme polygonale ou de tranches de matériau semi-conducteur de forme circulaire, comme du silicium.

Entre les différentes étapes de fabrication, les substrats sont transportés et stockés dans des enceintes étanches à atmosphère contrôlée qui les protègent des pollutions présentes dans l'atmosphère des salles blanches. Habituellement les enceintes contiennent un substrat (tranches de silicium de 200 millimètres de diamètre ou de 300 millimètres de diamètre) ou plusieurs substrats empilés. Actuellement les enceintes étanches couramment utilisées contiennent de 1 à 25 substrats. Les substrats reposent sur un support individuel et sont séparés par un espace qui est réduit au minimum afin d'avoir des enceintes de stockage de petites dimensions.
L'accouplement de ces enceintes étanches avec les interfaces d'entrée/sortie des équipements de fabrication est réalisé à l'aide de sas et de moyens robotisés. Un premier robot transporte le substrat depuis l'enceinte étanche de transport vers une chambre de chargement. La chambre de chargement est mis à basse pression. Puis le robot de la chambre de transfert transporte le substrat de la chambre de chargement à la chambre de procédé. L'espace disponible sous le substrat, lorsqu'il est placé dans la chambre de chargement ou dans l'enceinte de transport, doit être suffisant pour laisser passer le bras du robot sous le substrat dans un premier temps. Dans un deuxième temps, ce bras doit pouvoir se soulever suffisamment pour que le substrat ne repose plus sur son support mais sur le bras du robot, qui va alors pouvoir déplacer le substrat vers la chambre de procédé.

On comprend que les enceintes étanches qui doivent répondre aux contraintes mentionnées précédemment ont un volume important. Or la place disponible pour le stockage dans une salle blanche est réduite à cause du coût de réalisation et d'entretien qu'elle représente. La quantité d'enceintes, donc de substrats, qui peuvent y être stockées est limitée. Il s'agit donc de diminuer l'encombrement de ces enceintes étanches.

Le document US-2002/018,703 décrit une installation comportant une chambre de procédé reliée à une chambre de transfert communiquant avec des chambres de chargement, chacune contenant une cassette destinée au stockage temporaire des substrats semi-conducteurs. Les chambres de chargement sont connectées par des moyens de transport de substrat à une étagère comprenant des compartiments de stockage recevant les substrats. Un robot transfert le substrat de ce compartiment de stockage vers la cassette situées dans la chambre de chargement. Un mécanisme inclus dans la cassette comprend plusieurs plateaux et des moyens pour supporter les plateaux et guider leur déplacement. Pour l'insertion / extraction d'un substrat de la cassette, le plateau qui la supporte est éloigné des autres plateaux grâce aux moyens de support et de guidage qui écartent les plateaux empilés de part et d'autre du plateau choisi. Un dispositif de verrouillage bloque le plateau dans une position telle qu'il soit éloigné des plateaux adjacents situés au-dessus et en dessous de lui. Le plateau se trouve ainsi accessible en vue de sa manipulation par le robot.

En outre l'enceinte étanche doit permettre de conserver une atmosphère contrôlée autour des substrats pour éviter leur contamination pendant les phases de transport et de stockage. En effet les tranches peuvent rester pendant plusieurs semaines dans l'unité de fabrication de semi-conducteurs, entre les diverses étapes du procédé. Pendant cette durée, les substrats de semi-conducteur doivent être protégés contre tout risque de pollution provenant de la salle blanche, mais également du substrat lui-même. C'est l'une des raisons pour laquelle on prévoit de les transporter et de les stocker dans des enceintes étanches sous atmosphère contrôlée.

La présente invention a pour but de proposer une structure d'enceinte étanche pour le transport et le stockage de substrat semi-conducteur ayant un encombrement réduit par rapport aux enceintes de l'art antérieur, mais qui présentent cependant un espacement autour du substrat permettant son insertion et/ou extraction de l'enceinte par des moyens robotisés habituellement utilisés dans les installations existantes.
En outre l'enceinte selon l'invention doit permettre de conserver une atmosphère contrôlée autour des substrats, afin d'éviter leur contamination pendant les phases de transport et de stockage, en assurant une étanchéité suffisante de manière simple et à faible coût.
Enfin l'enceinte de transport doit pouvoir s'accoupler avec les interfaces de chargement / déchargement des équipements de fabrication courant.

L'objet de la présente invention est une enceinte étanche pour le transport et le stockage de substrats semi-conducteurs comprenant un conteneur étanche et des moyens placés à l'intérieur dudit conteneur comprenant des plateaux pour supporter lesdits substrats, caractérisée en ce que ledit conteneur comporte deux demi-coques jointives qui s'écartent pour assurer l'ouverture dudit conteneur, et en ce que chaque extrémité desdits moyens est mécaniquement solidaire de chacune desdites demi-coques respectivement.

Ainsi la hauteur totale des moyens varie selon que le conteneur est ouvert ou fermé, les plateaux étant séparés par une distance égale.
L'enceinte étanche selon la présente invention a comme avantage d'être peu encombrante une fois fermée, ce qui facilite le stockage et le transport. Du fait de son faible volume interne, la maîtrise de son atmosphère est plus simple, notamment vis à vis de la pollution. En outre son poids et son coût de réalisation sont moindres, et elle nécessite une interface de taille réduite avec l'installation.
Selon un mode de réalisation particulier, les moyens comportent une alternance de segments et de rotules. De préférence encore l'alternance de segments et de rotules comporte un segment à chaque extrémité, chacun des segments d'extrémité étant relié mécaniquement respectivement à chacune des demi-coques.
Avantageusement une rotule sur deux porte un plateau sur lequel repose le substrat. Dans ce cas la hauteur totale des moyens varie de préférence par un mouvement d'accordéon de l'alternance de segments et de rotules.
Les demi-coques composant le conteneur sont jointes par l'intermédiaire d'un joint souple. Les moyens en se rétractant compriment ledit joint souple pour assurer l'étanchéité dudit conteneur.

Pour faciliter la manipulation de l'enceinte, le conteneur comporte au moins une poignée et/ou un dispositif de verrouillage. De préférence le dispositif de verrouillage coopère avec la poignée.

La présente invention a aussi pour objet un procédé d'extraction d'un substrat d'une enceinte telle que décrite précédemment. L'enceinte à basse pression est placée dans une chambre de chargement également à basse pression. Le procédé comprend les étapes suivantes :
- on augmente la distance séparant les plateaux en écartant les demi-coques,
- on introduit un moyen robotisé entre deux plateaux contigus,
- on soulève le substrat placé au dessus dumoyen robotisé,
- on extrait le moyen robotisé et le substrat,
- on réduit la distance séparant les plateaux restant en joignant les demi-coques.

La présente invention a encore pour objet un procédé d'insertion d'un substrat dans une enceinte telle que décrite précédemment. L'enceinte à basse pression est placée dans une chambre de chargement à basse pression. Le procédé comprend les étapes suivantes :
- on augmente la distance séparant les plateaux en écartant les demi-coques,
- on introduit un moyen robotisé portant le substrat entre deux plateaux contigus,
- on dépose le substrat sur le plateau placé en dessous du moyen robotisé,
- on extrait le moyen robotisé.
- on réduit la distance séparant les plateaux en joignant les demi-coques.
   D'autres caractéristiques et avantages de la présente invention apparaîtront au cours de la description suivante de modes de réalisation donnés à titre illustratif, mais nullement limitatif, et dans le dessin annexé sur lequel
- la figure 1 est une vue schématique partielle en coupe verticale de l'enceinte de transport et de stockage selon l'invention en position de stockage,
- la figure 2 est une vue schématique partielle en coupe verticale de l'enceinte de la figure 1 lors de l'insertion ou de l'extraction d'un substrat,
- les figures 3A, 3B et 3C sont une vue schématique partielle en coupe de l'extraction d'un substrat de l'enceinte selon l'invention en vue de son transfert dans une chambre de procédé,
- la figure 4 montre un mode de réalisation particulier de l'invention,
- la figure 5 est une vue schématique en coupe horizontale de l'enceinte de transport et de stockage selon l'invention.

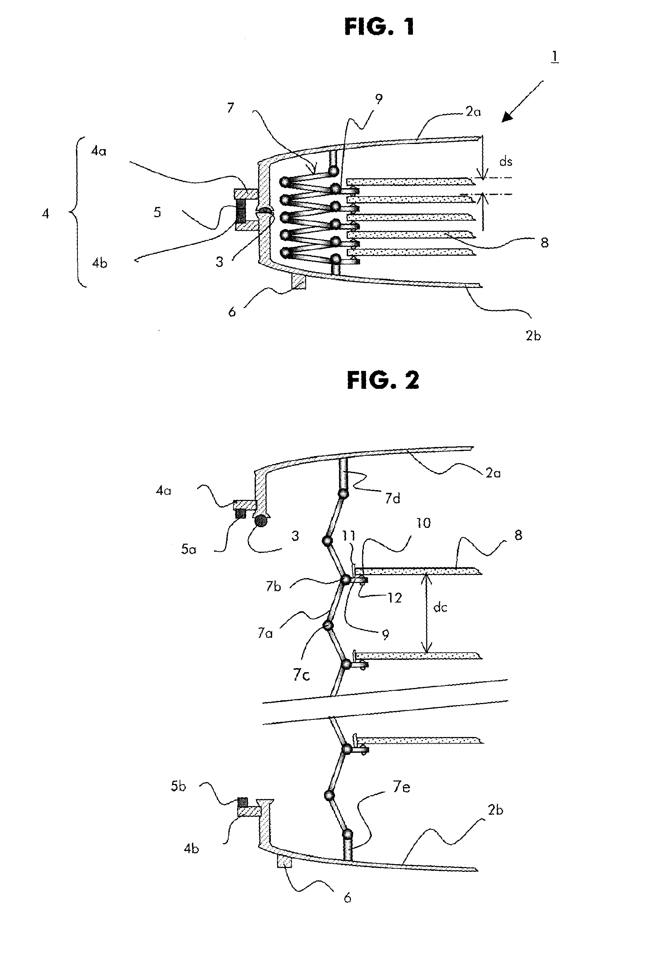

Dans le mode de réalisation de l'invention illustré sur la figure 1, on a représenté une enceinte **1** selon l'invention en position fermée pour le stockage. La figure 2 montre la même enceinte **1** en position ouverte pendant l'opération d'extraction ou d'insertion d'une tranche de substrat, lorsque l'enceinte **1** se trouve à l'intérieur d'une chambre de chargement/déchargement d'une installation de fabrication et de traitement. Des références identiques désignent les mêmes éléments que sur la figure 1.
L'enceinte **1** comporte un conteneur **2** formé d'une demi-coque supérieure **2a** et d'une demi-coque inférieure **2b.** Les deux demi-coques **2a** et **2b** sont en contact par l'intermédiaire d'un joint souple **3** qui est comprimé pour assurer l'étanchéité de l'enceinte **1.** La forme en arc de cercle des demi-coques **2a** et **2b** leur permet de mieux résister à la pression atmosphérique extérieure. L'enceinte 1 est munie d'une poignée de manipulation **4** composée de deux parties **4a** et **4b** respectivement reliées aux deux demi-coques **2a** et **2b.** La poignée 4 est munie d'un dispositif de verrouillage **5** pour prévenir toute ouverture intempestive. Ce dispositif de verrouillage **5** peut être ouvert par un robot à l'intérieur de la chambre de chargement de l'installation de traitement lorsqu'elle est sous vide. L'enceinte **1** peut avantageusement être pourvue de pieds **6** qui la stabilise sur une surface plane et facilite son alignement lors des manipulations automatisées.
A l'intérieur de l'enceinte **1** se trouve des moyens **7** pour supporter les tranches de substrat **8.** Les moyens **7** destinés à supporter les tranches de substrat **8** sont flexibles et capables de se déployer lorsque l'enceinte **1** est ouverte, comme le montre la figure 2, de manière à permettre l'accessibilité des tranches de substrat **8** à des moyens robotisés standards. Lorsque l'enceinte **1** est refermée, les moyens **7** se replient pour en minimiser la hauteur.
Les moyens **7** comportent des segments mobiles **7a** reliés entre eux par des rotules **7b, 7c.** L'ensemble des segments mobiles **7a** et des rotules **7b, 7c** qui les unissent est fixé par des segments de fixation 7d et 7e respectivement à la demi-coque supérieure **2a** et à la demi-coque inférieure **2b** de l'enceinte **1.** Lors de la fermeture de l'enceinte **1,** l'ensemble des segments mobiles **7a** et des rotules **7b, 7c** se replie en accordéon, de telle sorte qu'une rotule **7b** sur deux soit déportée vers le centre de l'enceinte **1,** et une rotule **7c** sur deux en alternance soit déportée vers l'extérieur. Les rotules **7b**, qui se déplacent vers le centre de l'enceinte **1** lors de la fermeture, portent des plateaux **9.** En position de stockage, l'enceinte **1** est fermée et les plateaux **9** sont espacés d'une distance ds. Une fois l'enceinte **1** ouverte pour le chargement/déchargement des tranches de substrat **8,** les plateaux **9** sont alors espacés d'une distance dc très supérieure à ds.
Un ergot **10** est disposé sur chaque plateau **9.** Les tranches de substrat **8** repose sur ces ergots **10** et sont en outre bloquées latéralement par des pièces de calage **11.** Les ergots **10** doivent avoir une surface parfaitement propre et exempte de particules polluantes. Un relief **12** est placé sous le plateau **9** au droit de l'ergot **10.** Les reliefs **12** sont des pièces flexibles, par exemple de type ressort ou bien constituées d'un matériau élastique comme un silicone ou un élastomère. Lorsque l'enceinte **1** est fermée en position de stockage, le relief **12** est en appui élastique sur la tranche de substrat **8** située immédiatement en dessous du plateau **9** qui le porte. Les reliefs **12** permettent de maintenir en position fixe les tranches de substrat **8,** afin de prévenir toute dégradation pendant le déplacement de l'enceinte **1** ou leur déformation au cours des périodes de stockage. Pour un maintien optimum des substrats **8,** un minimum de trois plateaux **9** est requis.

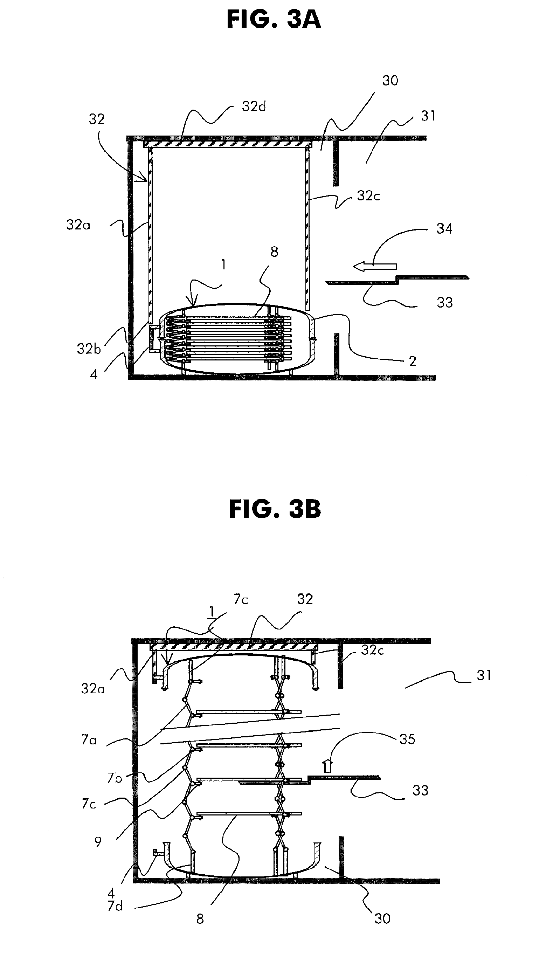

Les figures 3A à 3C montrent les étapes successives du déchargement d'une tranche de substrat. L'enceinte **1** en position refermée et dans laquelle règne une basse pression, est placée dans la chambre de chargement/déchargement **30** associée à la chambre de transfert **31** d'une installation de fabrication ou de traitement de substrats semi-conducteurs. La chambre de chargement **30** contient un système de compression mécanique **32** permettant l'ouverture et la fermeture de l'enceinte **1** et la chambre de transfert **31** contient un robot manipulateur **33** permettant de saisir et de déplacer le substrat **8.** Le système de compression **32** comprend, un bras extensible **32a** dont l'extrémité porte des moyens **32b** pour déverrouiller / verrouiller le dispositif de verrouillage **5** placé dans la poignée **4** de l'enceinte **1,** et des moyens associés **32c** pour ouvrir l'enceinte **1** en soulevant la demi-coque supérieure **2a.** Le bras **32a** et les moyens associés **32c** sont portés par un socle commun **32d** fixé sur la paroi de la chambre de chargement **30.**

On va maintenant expliquer comment s'effectue l'insertion, le transport et l'extraction d'un substrat **8** en utilisant l'enceinte **1** de transport et de stockage selon la présente invention.
Pour effectuer le chargement d'un ou plusieurs substrats **8** dans une enceinte **1** vide, l'enceinte **1** est ouverte à la pression atmosphérique de la salle blanche, puis placée dans la chambre de chargement/déchargement **30** de l'installation. La chambre de chargement **30** est refermée, et on effectue sa mise sous vide ce qui permet également de mettre sous vide l'enceinte **1** qui est ouverte. Quand l'enceinte **1** et la chambre de chargement **30** ont atteint une pression suffisamment basse, la chambre de transfert **31** également à basse pression s'ouvre. Le robot manipulateur **33** dispose de l'espace nécessaire pour placer un ou plusieurs substrats dans l'enceinte. Une fois que le ou les substrats **8** sont placés dans l'enceinte **1,** un système de compression mécanique **32,** de type vérin ou ressort, appuie sur l'enceinte **1** de transport, ce qui a pour conséquences de :
- comprimer les moyens **7** flexibles de support des substrats **8** placés dans l'enceinte **1,** de telle sorte que les deux demi-coques **2a, 2b** arrivent en contact l'une avec l'autre, se joignent de manière étanche grâce au joint **3** et se solidarisent au moyen du dispositif de verrouillage **5;**
- bloquer les substrats **8** à l'intérieur de l'enceinte **1** par un système de blocage et de positionnement mécanique comprenant les reliefs **12** et les ergots **10** associés aux pièces **11** de centrage et de maintien.
   La taille de l'enceinte **1** étant réduite au minimum grâce à la compression exercée, elle peut être aisément transportée vers un lieu de stockage ou tout autre équipement compatible. Le nombre d'enceintes qui peuvent être stockées dans un volume donné est donc sensiblement augmenté par rapport à l'art antérieur.
   Enfin l'enceinte **1** étant maintenue en compression par le système de compression mécanique **32,** la chambre de chargement **30** est progressivement remise à pression atmosphérique, ce qui a pour effet de maintenir l'enceinte **1** en position fermée grâce à la différence de pression entre la pression atmosphérique de la chambre de chargement **30** et la basse pression à l'intérieur de l'enceinte **1.** Le système de compression mécanique **32** peut alors être désactivé car son effet est compensé naturellement par la différence de pression. Toutefois, par sécurité face à d'éventuelles fuites, le système de compression mécanique **32** peut rester activé pendant l'ouverture de la chambre de chargement **30** qui permet de récupérer l'enceinte **1** chargée et à basse pression. L'étanchéité de l'enceinte **1** est alors maintenue naturellement par la différence de pression entre l'intérieur de l'enceinte **1** à basse pression et l'environnement extérieur de la salle blanche à pression atmosphérique. Une double sécurité est donc mise en place pour éviter toute fuite : d'une part le dispositif de verrouillage **5** qui permet de maintenir en compression le joint **3** et les moyens flexibles **7** à l'intérieur de l'enceinte **1**, et d'autre part la contrainte exercée par la pression atmosphérique externe de la salle blanche qui assure une compression mécanique légère autour de l'enceinte **1.**

Pour le déchargement d'un ou plusieurs substrats **8,** l'enceinte **1,** fermée et maintenue à basse pression et en compression par le dispositif de verrouillage **5,** est introduite dans la chambre de chargement **30** qui se trouve à la pression atmosphérique de la salle blanche comme le montre la figure 3A. La chambre de chargement **30** est alors mise sous vide progressivement. L'enceinte **1** va peu à peu se détendre. Tant que la pression dans la chambre **30** est supérieure à la pression interne de l'enceinte **1,** la pression exerce sur le conteneur **2** une force s'opposant à l'ouverture de l'enceinte **1.** Le déverrouillage de la poignée **4** est effectué lorsque la pression dans la chambre de chargement **30** est égale à la pression interne de l'enceinte **1.** L'ouverture de l'enceinte **1** est limitée en hauteur par le système de compression **32** précédemment décrit agissant en butée haute (fig. 3B).

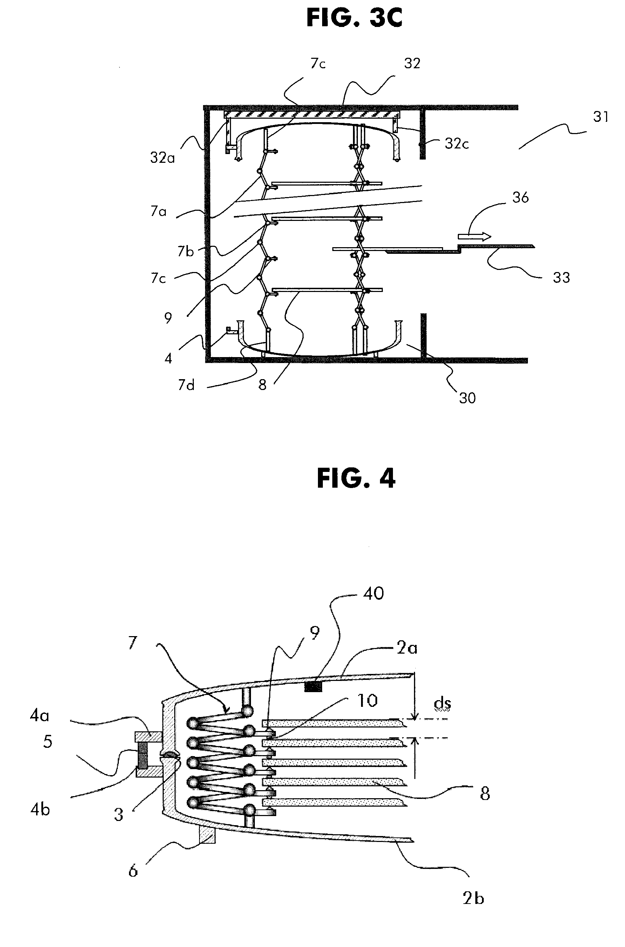

Une fois l'enceinte **1** en position ouverte, le robot manipulateur **33** peut venir chercher les substrats **8** devenus accessibles. Un bras du robot manipulateur **33** est introduit entre deux plateaux dont l'écartement le permet comme le montre la flèche **34** sur la figure 3A. Il soulève le substrat placé au-dessus de lui comme le montre la flèche **35** sur la figure 3B. Puis le robot manipulateur **33** portant le substrat se retire selon la flèche **36** de la figure 3C.

Selon un mode de réalisation particulier représenté sur la figure 4, l'enceinte **1** est équipée d'un capteur de pression **40** qui mesure la pression interne de l'enceinte **1.** La mesure effectuée est transmises par signal radio (RF). Il permet de déterminer le moment exact de l'ouverture de l'enceinte **1** et peut éventuellement servir aussi au pilotage permanent de l'environnement interne de l'enceinte **1.** Le récepteur de signal peut être positionné soit dans la chambre **30** soit à l'extérieur de l'installation. Selon une variante, le système peut être également équipé de capteurs de température, d'humidité, et/ou de capteurs mesurant une autre propriété des gaz.

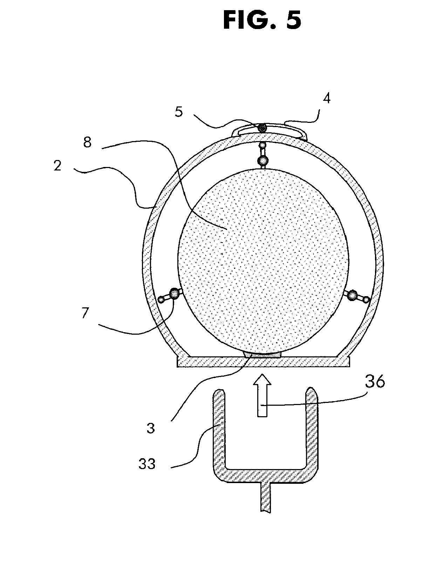

La figure 5 représente une coupe horizontale de l'enceinte **1** vue de dessus. Des moyens **7** sont disposés en triangle autour du substrat **8** afin de le maintenir en place lors de la manipulation de l'enceinte **1.** Le bras du robot manipulateur **33** est placé du côté du conteneur **2** de l'enceinte **1** qui est opposé à la poignée **4** munie du dispositif de verrouillage **5.** Le joint **3** une fois comprimé se projette à l'intérieur de l'enceinte **1** et contribue au maintien du substrat **8.**

## Revendications

1. Enceinte étanche pour le transport et le stockage de substrats semi-conducteurs comprenant un conteneur étanche et des moyens placés à l'intérieur dudit conteneur comprenant des plateaux pour supporter lesdits substrats, **caractérisée en ce que** ledit conteneur comporte deux demi-coques jointives qui s'écartent pour assurer l'ouverture dudit conteneur, et **en ce que** chaque extrémité desdits moyens est mécaniquement solidaire de chacune desdites demi-coques respectivement.

2. Enceinte selon la revendication 1, dans laquelle la hauteur totale desdits moyens varie selon que ledit conteneur est ouvert ou fermé, lesdits plateaux étant séparés par une distance égale.

3. Enceinte selon l'une des revendications 1 et 2, dans laquelle lesdits moyens comportent une alternance de segments et de rotules.

4. Enceinte selon la revendication 3, dans laquelle ladite alternance de segments et de rotules comporte un segment à chaque extrémité, chacun desdits segments d'extrémité étant relié mécaniquement respectivement à chacune desdites demi-coques.

5. Enceinte selon l'une des revendications 3 et 4, dans laquelle la hauteur totale desdits moyens varie par un mouvement d'accordéon de l'alternance de segments et de rotules.

6. Enceinte selon l'une des revendications 3 à 5, dans laquelle une rotule sur deux porte un plateau sur lequel repose ledit substrat.

7. Enceinte selon l'une des revendications précédentes, dans laquelle lesdites demi-coques sont jointes par l'intermédiaire d'un joint souple.

8. Enceinte selon la revendication 7, dans laquelle lesdits moyens compriment ledit joint souple pour assurer l'étanchéité dudit conteneur.

9. Enceinte selon l'une des revendications précédentes, dans laquelle ledit conteneur comporte au moins une poignée.

10. Enceinte selon l'une des revendications précédentes, dans laquelle ledit conteneur comporte un dispositif de verrouillage.

11. Enceinte selon l'une des revendications 9 ou 10, dans laquelle ledit dispositif de verrouillage coopère avec ladite poignée.

12. Procédé d'extraction d'un substrat d'une enceinte selon l'une des revendications précédentes, dans lequel ladite enceinte à basse pression est placée dans une chambre de chargement à basse pression, **caractérisé en ce qu'**il comprend les étapes suivantes :
- on augmente la distance séparant les plateaux en écartant les demi-coques,
- on introduit un moyen robotisé entre deux plateaux contigus,
- on soulève le substrat placé au dessus dumoyen robotisé,
- on extrait le moyen robotisé et le substrat,
- on réduit la distance séparant les plateaux restant en joignant les demi-coques.

13. Procédé d'insertion d'un substrat dans une enceinte selon l'une des revendications précédentes, dans lequel ladite enceinte à basse pression est placée dans une chambre de chargement à basse pression, **caractérisé en ce qu'**il comprend les étapes suivantes :
- on augmente la distance séparant les plateaux en écartant les demi-coques,
- on introduit un moyen robotisé portant le substrat entre deux plateaux contigus,
- on dépose le substrat sur le plateau placé en dessous du moyen robotisé,
- on extrait le moyen robotisé.
- on réduit la distance séparant les plateaux en joignant les demi-coques.
